Europäisches Patentamt

European Patent Office

Office européen des brevets

(11) Veröffentlichungsnummer : **0 081 764**
**B1**

# EUROPÄISCHE PATENTSCHRIFT

(45) Veröffentlichungstag der Patentschrift :
06.07.88

(51) Int. Cl.⁴ : **H 03 M   1/66**

(21) Anmeldenummer : 82111173.9

(22) Anmeldetag : 02.12.82

(54) Integrierbare Schaltung für Digital/Analog-Wandler.

(30) Priorität : 10.12.81 DE 3148956

(43) Veröffentlichungstag der Anmeldung :
22.06.83 Patentblatt 83/25

(45) Bekanntmachung des Hinweises auf die Patenterteilung : 06.07.88 Patentblatt 88/27

(84) Benannte Vertragsstaaten :
AT DE FR GB IT

(56) Entgegenhaltungen :
US-A- 3 588 880
INSTRUMENT CONSTRUCTION, Nr. 9, September 1963, Seiten 12-14, Oxford, GB; V.N. USTIMENKO et al.: "Automatic control equipment"

(73) Patentinhaber : Siemens Aktiengesellschaft Berlin und München
Wittelsbacherplatz 2
D-8000 München 2 (DE)

(72) Erfinder : Wondra, Jürgen, Ing.(grad.)
Hauptstrasse 23 a
D-8014 Neubiberg (DE)

## Beschreibung

Die Erfindung bezieht sich auf eine integrierbare Schaltung für Digital/Analog-Wandler, bei der die einzelnen, durch je einen Teil des zu verarbeitenden Digitalsignals beaufschlagten Signaleingänge mit demselben Anschluß je einer ersten Diode und der zweite Anschluß dieser ersten Diode mit demselben Anschluß je einer zweiten Diode verbunden ist und außerdem am Ausgang je eines als Stromquelle betriebenen Transistors liegt, während der andere Anschluß der zweiten Diode der von den einzelnen Signaleingängen gesteuerten Diodenpaare zur gemeinsamen Steuerung eines Ausgangsverstärkers vorgesehen ist, bei der weiterhin der stromführende Eingang der einzelnen Stromquellentransistoren über je einen Widerstand von einem gemeinsamen Versorgungsanschluß her beaufschlagt ist, und bei der schließlich sowohl die einzelnen Diodenpaare einander gleich als auch die Stromquellentransistoren vom selben Typ sind.

Digital/Analog-Wandler dieser Art sind üblich und können z. B. in der aus dem Buch « Halbleiter-Schaltungstechnik » von Tietze und Schenk (1980), S. 640 und 641, ersichtlichen Weise ausgestaltet sein. Bei der bekannten Ausgestaltung sind die einzelnen Stromquellentransistoren durch gemeinsam gesteuerte Bipolartransistoren gegeben, die mit den Kathoden der beiden zugeordneten Dioden verbunden sind. Die Anode der ersten Diode des jeweiligen Diodenpaares liegt am zugehörigen Eingang der betreffenden Stufe des D/A-Wandlers, während die Anode der zweiten Diode — gemeinsam mit den Anoden der entsprechenden zweiten Diode aus den übrigen Stufen des D/A-Wandlers — am invertierenden Eingang eines durch einen Widerstand gegengekoppelten Operationsverstärkers, dem Ausgangsverstärker des Wandlers, liegen.

Andererseits sind die Stromeingangselektroden, also die Emitter der Stromquellentransistoren, über je einen Widerstand entweder unmittelbar an einen Versorgungsanschluß oder unter Verwendung eines Spannungsteilers an den besagten Versorgungsanschluß gelegt. Der zuletzt angedeutete Fall ist dann gegeben, wenn die Stromquellentransistoren Bestandteil eines Leiternetzwerks, z. B. eines R-2R-Netzwerks, sind.

Häufig tritt der Fall auf, daß in einer integrierten Schaltung zwei oder mehrere einander gleiche D/A-Wandler benötigt werden. Dabei spielt es hinsichtlich des Platzbedarfs der D/A-Wandler auf dem Chip sowie der Herstellungskosten der integrierten Schaltung eine erheblich ungünstige Rolle, daß jeder dieser D/A-Wandler mit den zu den Stromeingangselektroden der Stromquellentransistoren führenden Widerständen bzw. einem Leiternetzwerk versehen werden muß. Es wäre deshalb wünschenswert, wenn der diesbezügliche Aufwand reduziert werden könnte.

Hierzu ist gemäß der Erfindung vorgesehen, daß jedem der vorgesehenen Stromquellentransistoren je ein zweiter ihm gleicher Stromquellentransistor zugeordnet ist, indem die Stromeingangselektroden beider Stromquellentransistoren unmittelbar miteinander verbunden bzw. identisch sind, während die Stromausgangselektroden der beiden jeweils einander zugeordneten Stromquellentransistoren mit je einem von zwei übereinstimmenden aber unabhängig von einander wirkenden, digital gesteuerten Schaltungsteilen der eingangs definierten Art verbunden sind.

Anders ausgedrückt bedeutet dies, daß zwei einander gleiche Digital/Analog-Wandler W1 und W2 dieselben die Verbindung zwischen den Stromquellentransistoren und dem das erforderliche Betriebspotential liefernden Versorgungsanschluß bildenden Widerstände gemeinsam benutzen. Es ist somit für beide D/A-Wandler nur eine einzige Widerstandskombination, z. B. nur ein einziges Leiternetzwerk, erforderlich, obwohl die beiden D/A-Wandler völlig unabhängig voneinander digital beaufschlagt sind.

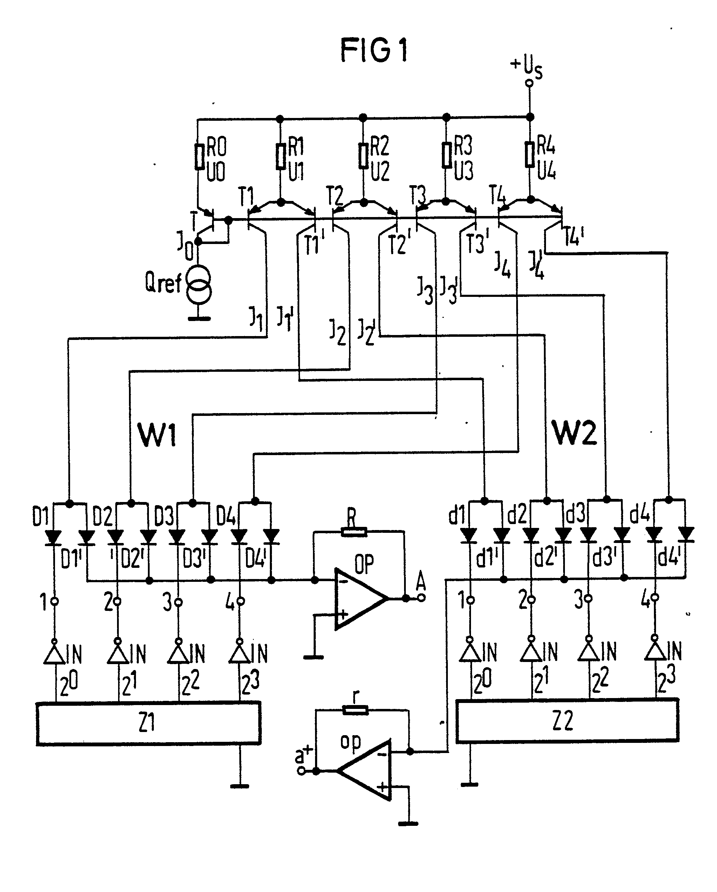

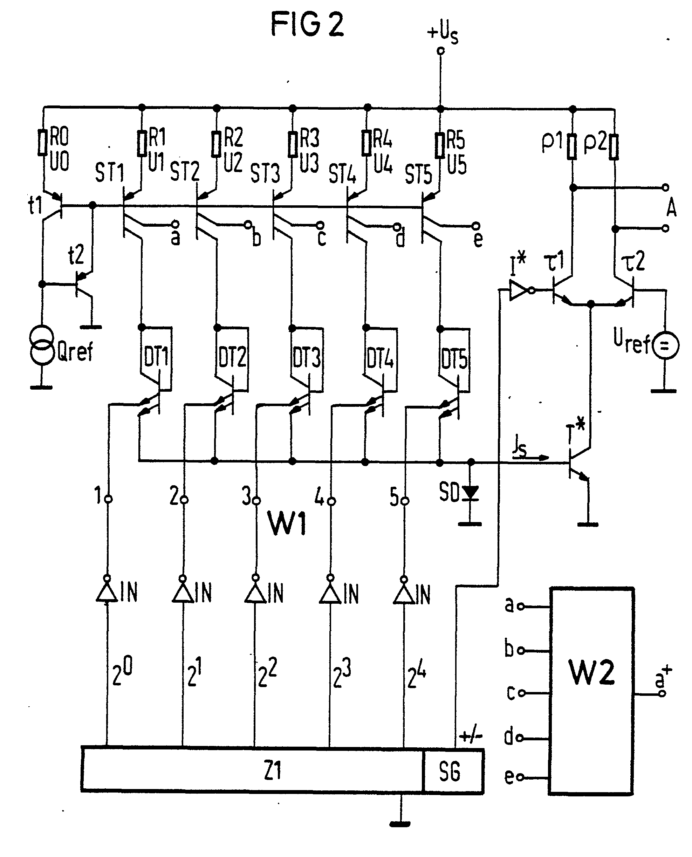

Zunächst wird die Erfindung anhand der beiden Figuren 1 und 2, die je ein Ausführungsbeispiel der Erfindung zeigen, weiter vorgestellt, bevor dann anhand dieser Ausführungsbeispiele die Wirkungsweise der Erfindung näher beschrieben wird.

Bei der aus Figur 1 ersichtlichen Ausgestaltung sind beide Wandler W1 und W2 im Detail dargestellt, während in Figur 2, der eine Wandler W2 mit Ausnahme seiner Stromquellentransistoren lediglich als Block gezeichnet ist. Zu bemerken ist noch, daß es ohne weiteres möglich ist, daß mehr als zwei Wandler eine Widerstandskombination gemeinsam benutzen.

Zur Beaufschlagung der beiden Wandler W1 und W2, die in dem in Fig. 1 dargestellten Beispiel jeweils zur Verarbeitung von Digitalworten zu je vier Bits dienen, ist eine Digitalschaltung, z. B. je ein binärer Digitalzähler Z1 bzw. Z2, vorgesehen, wobei die den Zählstand vermittelnden Ausgänge des Zählers nach Maßgabe der jeweiligen Bitwertigkeit unter Verwendung je eines Inverters IN je einen Signaleingang des betreffenden Wandlers W1 bzw. W2 bilden. Diese Eingänge 1, 2, 3, 4 sind derart beaufschlagt, daß der Eingang 1 das MSB-Signal und der Eingang 4 das LSB-Signal erhält. Jeder der Eingänge 1 bis 4 ist an je eine Kombination zweier einander gleicher Dioden gelegt, die beim Wandler W1 mit D1, D1', ... D4, D4' und im Wandler W2 mit d1, d1', ... d4, d4' bezeichnet sind.

Entsprechend der Definition der Erfindung liegt dabei die Kathode der jeweils ersten Diode, also die Diode ohne das Zeichen « ' » im Kennzeichen, der genannten Diodenpaare (also die Kathode der Dioden D1, D2, D3, D4 bzw. d1', d2', d3', d4'), an dem invertierten Eingang « - » des dem betreffenden Wandler W1 bzw. W2 zugeordneten Operationsverstärkers OP bzw. op. Letztere sind mittels eines Widerstandes R bzw. r gegengekoppelt und bilden mit ihrem Ausgang A bzw. a⁺ den das gewünschte Analogsignal liefernden Ausgang des betreffenden Wandlers.

Anstelle eines Zählers Z1 bzw. Z2 kann als Quelle für die jeweils zu verarbeitenden Digitalsignale zu je 4 Bit z. B. auch ein Serienspeicher, Verwendung finden. Auch kann die Beaufschlagung der beiden Wandler W1 und W2 durch unterschiedliche digitale Schaltungsteile erfolgen.

Die Anoden der paarweise zusammengehörenden Dioden D1, D1', ... D4, D4' bzw. d1, d1', ... d4, d4' sind jeweils miteinander verbunden und an den Kollektor (also die Stromausgangselektrode) je eines Transistors gelegt, der als Stromquelle geschaltet ist. Diese Transistoren sind mit T1-T4 beim ersten Wandler W1 und mit T1'-T4' beim zweiten Wandler W2 bezeichnet.

Die Stromquellentransistoren T1-T4 des ersten Wandlers W1 sowie die Stromquellentransistoren T1'-T4' des zweiten Wandlers W2 sind alle einander gleich und bilden zusammen mit einem gemeinsamen und als Diode geschalteten weiteren Transistor T je einen Stromspiegel und damit je eine Konstantstromquelle. Der als Diode geschaltete Transistor Tist vom selben Typ wie die übrigen Stromquellentransistoren T1-T4 bzw. T1'-T4'. Er liegt mit seinem Kollektor und seiner Basis über einer Referenzstromquelle $Q_{ref}$ am Bezugspotential der Schaltung. Die Referenzstromquelle $Q_{ref}$ liefert einen der Einstellung der einander gleichen Stromquellentransistoren entsprechenden Versorgungsstrom, der außerdem noch durch gewichtete Widerstände bestimmt wird.

Hierzu ist der Emitter jedes Stromquellentransistors T1-T4 des ersten Wandlers zusammen mit dem Emitter des jeweils digital entsprechenden Stromquellentransistors T1'-T4' des zweiten Wandlers über den jeweils zugehörigen und entsprechend der betreffenden Digitalwertigkeit gewichteten Widerstand R1 bzw. R2 bzw. R3 bzw. R4 an das andere Versorgungspotential $+U_s$ gelegt.

Es empfiehlt sich, wenn die in den Ausgangsverstärkern OP bzw. op der beiden Wandler W1 bzw. W2 in üblicher Weise vorgesehenen Transistoren vom npn-Typ und die Stromquellentransistoren vom pnp-Typ sind und dabei außerdem die Schaltdioden D1-D4 bzw. D1'-D4' bzw. d1-d4 bzw. d1'-d4' dann mit ihrer p-leitenden Zone an den Kollektor des zugehörigen Stromquellentransistors angeschlossen sind. Offensichtlich ist dies auch bei der Ausgestaltung gemäß Figur 2 der Fall. Zu erwähnen ist außerdem, daß der als Diode geschaltete Transistor T im Stromspiegel ggf. über einen Widerstand $R_o$ an das andere Versorgungspotential $+U_s$ gelegt sein kann.

Schließlich ist verständlich, daß bei entsprechender Wahl von Bezugspotential und des anderen Versorgungspotentials die Stromquellentransistoren T, T1, T1' usw. auch durch npn-Transistoren realisiert sein können. Dann wird man zweckmäßig die übrigen Transistoren der Schaltung, d. h. also die Transistoren in den Ausgangsverstärkern OP, op und die in den Schaltteilen IN, Z1 und Z2 verwendeten Transistoren als pnp-Transistoren ausgestalten. Die in Figur 1 und Figur 2 dargestellte Version erscheint jedoch im Interesse eines rascheren Ansprechens der Wandler W1 und W2 als vorteilhafter. Schließlich können noch weitere Wandler W3 uzw. vorgesehen sein, die dann in der gleichen Weise wie die Wandler W1 und W2 ausgestaltet und an die gemeinsame Widerstandskombination R1 ... R4 unter Verwendung je eines den übrigen Stromquellentransistoren gleichen Stromquellentransistors gelegt sind.

Die in Figur 2 dargestellte Ausgestaltung einer D/A-Wandlerschaltung gemäß der Erfindung unterscheidet sich von der Ausgestaltung gemäß Figur 1 vor allem darin, daß sowohl die Diodenpaare D1, D1', ... D4, D4', D5, D5' (die einzelnen Wandler W1 und W2 haben in dem in Figur 2 dargestellten Ausführungsbeispiel jeweils 5 Digitaleingänge ; außerdem ist, wie bereits oben bemerkt nur der Wandler W1 im Detail dargestellt) durch jeweils einen zwei Emitter aufweisenden npn-Transistor DT1 bzw. DT2 bzw. DT3 bzw. DT4 bzw. DT5 realisiert sind, als auch die zu den einzelnen Wandlern W1, W2 gehörenden Stromquellentransistoren zu je einem Transistor zusammengefaßt sind.

Zur Realisierung der Diodenpaare in den einzelnen Wandlern ist pro Diodenpaar ein Zwei-Emitter-npn-Transistor DT1 ... DT5 vorgesehen, wobei der eine Emitter dieser Transistoren an den jeweils zugehörigen Signaleingang 1-5 des betreffenden Wandlers W1 bzw. W2 und der andere Emitter an den gemeinsamen Eingang des Ausgangsverstärkers AV gelegt ist. Dieser Eingang ist in dem in Figur 2 dargestellten Beispielsfall durch die Basis eines als Konstantstromquelle geschalteten npn-Transistors T* gegeben, die außerdem über eine (z. B. ebenfalls durch einen npn-Transistor realisierte) Summationsdiode SD, mit deren Anode sie verbunden ist, an das Bezugspotential (Masse) der Schaltung gelegt ist. Der Emitter dieses als Konstantstromquelle betriebenen npn-Transistors T* liegt ebenfalls am Bezugspotential, während sein Kollektor mit dem Emitter zweier als Differenzverstärker miteinander verbundener npn-Transistore 1 bzw. 2 in üblicher Weise zusammengeschaltet ist. Die Kollektoren dieser beiden zuletzt genannten npn-Transistoren $\tau1$ und $\tau2$ bilden die beiden Ausgangsklemmen A des Ausgangsverstärkers AV und sind außerdem über je einen Widerstand $\rho1$ bzw. $\rho2$ mit dem anderen Betriebspotential $+U_s$ verbunden. Der eine Signaleingang des Differenzverstärkers, d. h. die Basis des Transistors $\tau1$, ist über einen Inverter I* an ein Umschaltsignal « +/— », welches die Berücksichtigung eines Vorzeichens gewährleistet, gelegt, während der durch die Basis des Transistors $\tau2$ gegebene Eingang von einer auf das Bezugspotential bezogenen Referenzgleichspannungsquelle $U_{ref}$ beaufschlagt ist.

Wesentlich für die Erfindung ist jedoch vor allem die aus Figur 2 ersichtliche Ausgestaltung der jeweils aus den beiden Wandlern W1 und W2 einander zugeordneten und über je einen gemeinsamen Widerstand R1, ... R5 an das andere Versorgungspotential $+U_s$ gelegten pnp-Stromquellentransistoren, indem diese zu jeweils einen Zwei-Kollektor-pnp-Transistor ST1 bis ST5 zusammengefaßt sind. Dabei ist der eine Kollektor dieser Transistoren ST1-ST5 an die Basis und den Kollektor des jeweils zugehörigen Zwei-Emitter-npn-Transistors DT1, ... DT5 des ersten Wandlers W1 und der zweite Kollektor an die Basis und den Kollektor des jeweils zugehörigen Zwei-Emitter-npn-Transistors im zweiten Wandler W2 gelegt. Da in der Zeichnung aus Platzgründen lediglich der Wandler W1 im Detail dargestellt und für den zweiten Wandler lediglich ein Block gezeichnet ist, sind die genanten Anschlüsse der Zwei-Emitter-Transistoren des zweiten Wandlers nur durch je einen Buchstaben a, ... e angedeutet, ohne selbst dargestellt zu sein.

Über ihre Basisanschlüsse sind die besagten Zwei-Kollektor-pnp-Transistoren ST1 bis ST5 gemeinsam mit der Basis eines weiteren pnp-Transistors t1 sowie mit dem Emitter eines zweiten weiteren pnp-Transistors t2 verbunden, wobei die Basis-Kollektorstrecke des Transistors t1 durch die Emitter-Basisstrecke des Transistors t2 überbrückt und der Emitter dieses Transistors t1 über einen Widerstand $R_0$ and das andere Versorgungspotential $+U_s$ gelegt ist. Der Kollektor des Transistors t2 liegt am Bezugspotential und die Basis von t2 sowie der Kollektor des pnp-Transistors t1 über die Referenzstromquelle $Q_{ref}$ ebenfalls am Bezugspotential. Auf diese Weise wird eine Verbesserung der Stromquellentransistoren im Vergleich zu der einfacheren Schaltung gemäß Figur 1 erreicht.

Wie bereits festgestellt wurde, sind die Widerstände $R_i$, die den einzelnen Stromquellentransistorpaaren $T_i$ bzw. $T_i'$ bzw. $ST_i$ zugeordnet sind, digital gewichtet, und zwar derart, daß der von dem Stromquellentransistor $T_i$ und $T_i'$ bzw. $ST_i$ der i-ten Stufe des betreffenden Wandlers auf das zugehörige Diodenpaar $D_i$, $D_i'$ bzw. $d_i$, $d_i'$ bzw. den dieses Diodenpaar ersetzenden Zwei-Emitter-Transistor $ST_i$ übertragene Strom $J_i$ der Bedingung $J_i = const. \cdot 2^{(i-1)}$ genügt, wobei i = 1, 2, ... n und n die Gesamtzahl der in jedem der beiden Wandler W1 und W2 vorgesehenen Digitalstufen ist. Das Eingangsbit der betreffenden Stufe hat die Wertigkeit $2^{(i-1)}$. In dem in Figur 1 dargestellten Aufführungsbeispiel ist somit n = 4 und in dem Beispiel gemäß Figur 5 ist n = 5.

Ersichtlich wird bei den in Figur 1 und 2 dargestellten Beispielen einer D/A-Wandlerschaltung gemäß der Erfindung ein aus einer Stromspiegelschaltung mit den Ausgangstransistoren $T_i$, $T_i'$ bzw. $ST_i$ stammender Strom $J_i$ bzw. $J_i'$ an die durch die Diodenpaare bzw. die Transistoren $DT_i$ gegebenen Umschalter der einzelnen Stufen i des D/A-Wandlers abgegeben, wobei die Wichtung dieser Ströme $J_i$ (bzw. J') entsprechend der Formel $J_i = const. \cdot 2^{(i-1)}$ über die Widerstände $R_0$ und $R_i$ erreicht wird. Die Referenzstromquelle $Q_{ref}$ erzeugt am Widerstand $R_0$ (derden Emitter des als Diode geschalteten pnp-Transistors T bzw. t1 mit dem anderen Versorgungspotential $+U_s$ verbindet, einen Spannungsabfall $U_0 = R_0 \cdot J_{ref}$. An den Widerständen $R_i$, also den Widerständen R1, R2, ... usw., stellt sich die

gleiche Spannung $U_1 = U_2 = ... = U_n$ ein, wenn man dafür sorgt, daß die durch die unterschiedliche Stromdichte in den Transistoren $T_0$ und $T_i$ hervorgerufene Schwellendifferenz vernachlässigt werden kann. Dies kann man z. B. durch eine entsprechende Anpassung der Transistorflächen im IC oder auch dadurch erreichen, daß man dafür sorgt daß der Spannungsabfall am Emitterwiderstand $R_0$ des als Diode im Stromspiegel geschalteten Transistors T (bzw. t1 und t2) erheblich größer als die Schwellenspannung der Stromquellentransistoren $T_i$ bzw. $ST_i$ ist. Durch entsprechende Einstellung der Widerstandswerte der Widerstände $R_i$ können somit die von den Kollektoren der Stromquellentransistoren $T_i$ bzw. $T_i'$ bzw. $ST_i$ gelieferten Ströme $J_i$ bzw. $J_i'$ eingestellt werden.

Im Hinblick auf Figur 2 soll noch im Zusammenhang mit dem durch den durch die Summationsdiode SD und den durch die Gesamtheit der Zwei-Emitter-Transistoren $DT_i$ gesteuerten Stromquellentransistor T* gesteuerten Differenzverstärker $\tau1$ und $\tau2$ noch auf folgendes aufmerksam gemacht werden. Die Beaufschlagung des bereits genannten Inverters I* durch einen Schaltungsteil SG des der digitalen Beaufschlagung je eines der vorgesehenen Wandler W1 und W2 dienenden Digitalgerätes Z1 bzw. Z2 durch ein Signal « +/— » macht es möglich, daß die Wandlerkapazität gegenüber der durch die Anzahl der Stufen i der Wandler W1 bzw. W2 um je ein Bit vergrößert wird. Hierbei wird das Prinzip der Höhen-/Tiefeneinstellung angewendet, wie es in der Audio-Technik üblich ist.

Bei den in Figur 1 und 2 gezeigten Beispielsfällen sind jeweils nur zwei einander gleiche Wandler an ein gemeinsames Widerstandswerk $R_i$ mit binärer Wichtung gelegt. Es können aber auch mehr als zwei einander gleiche Wandler an das gemeinsame Widerstandswerk $R_i$ in identischer Weise angeschlossen sein. Ist die Anzahl der einander gleichen D/A-Wandler gleich m, so werden pro Digitalstufe i entweder m gleiche Stromquellentransistoren entsprechend den Transistoren $T_i$, $T_i'$ mit ihrem Kollektor an den jeweils zugehörigen Wandler in der bereits beschriebenen Weise angelegt und gemeinsam mit ihren Emittern mit dem zugehörigen Widerstand $R_i$ und damit mit dem anderen Versorgungspotential $+U_s$ verbunden. Oder man verwendet als Stromquellentransistoren n einander gleiche m-Kollektor-Transistoren $ST_i$ vom pnp-Typ, deren Emitter in der anhand von Fig. 2 ersichtlichen Weise an den zugehörigen Widerstand $R_i$ gelegt und deren Basen gemeinsam durch den als Diode geschalteten pnp-Transistor T gesteuert sind. Die m Kollektoren jedes dieser Transistoren $ST_i$ sind dann an das zugehörige Diodenpaar jedes der vorgesehenen Wandler bzw. den zugehörigen Zwei-Emitter-npn-Transistor $DT_i$, der dieses Diodenpaar ersetzt, in der aus Figur 1 bzw. Figur 2 ersichtlichen Weise gelegt.

Unter der Voraussetzung, daß die Wichtung der von den Stromquellentransistoren $T_i$, $T_i'$ bzw. $ST_i$ gelieferten Ströme $J_i$ ausschließlich durch den

zugehörigen Widerstand $R_i$ bzw. durch die Anschaltung an ein R-2R-Netzwerk bestimmt ist, gilt für den Strom $J_i$ die Beziehung

$$J_i = J_{ref} \cdot R_o/m \cdot R_i$$

Hat dann der Eingang 1 das LSB-Signal und der Eingang n (im Beispiel gemäß Fig. 1 ist n = 4, im Beispiel gemäß Fig. 2 ist n = 5. n kann aber auch jeden anderen ganzahligen Wert haben) das MSB-Signal, wie dies auch in den beiden Figuren zum Ausdruck gebracht ist, so hat der Widerstand in der MSB-Stufe, also der Widerstand $R_n$, den Wert $R_o/2$, der Widerstand $R_{n-1}$ in der Stufe (n—1) den Wert $R_o$ usw.. Allgemeinen gilt für die Bemessung des Widerstands $R_i$

$$R_i = R_o \cdot 2^{(n-i-1)},$$

wobei i = 1, 2, ... n sein kann.

Die Ströme $J_i$ fließen über die zugehörigen Entkopplungsdioden $D_i$ beziehungsweise $D_i'$, die wie in Fig. 2 gezeigt, als npn-Transistoren mit doppeltem Emitter realisiert werden können, entweder an den zugehörigen Digitaleingang i und damit in die Aussteuergatter IN aus dem den betreffenden Wandler W1 oder W2 beaufschlagenden Digitalteil, oder in die Summierdiode SD. Der dabei an die Summierdiode SD gelangende Strom $J_s$ wird über einen Stromspiegeltransistor T* entnommen und kann über die durch die Transistoren 1 und 2 gebildete Differenzstufe — abhängig von einem über den Inverter I* gelieferten Vorzeichen-Bit — bei Bedarf umgeschaltet werden.

Anstelle der gewichteten Widerstände $R_i$ kann für die Erreichung der gewichteten Ströme $J_i$ aus den einzelnen Stromquellentransistoren $T_i$ bzw. $T_i'$ bzw. $ST_i$ ein R-2R-Netzwerk als Widerstandswerk verwendet werden, das in üblicher Weise an die Emitter der zu der Stufe i gehörenden Stromquellentransistoren angeschlossen ist. Dies bedeutet nun, daß das Potential $+U_s$ am einen Ende eines aus n einander gleichen Widerständen R bestehenden Spannungsteilers gelegt ist, der über einen weiteren Widerstand 2R mit dem Bezugspotential Verbunden ist. Von den einzelnen Teilerpunkten dieses Spannungsteilers geht je ein über je einen Widerstand 2R geführter Strom aus, der zur Beaufschlagung der Emitter bzw. des Emitters des zugehörigen Stromquellentransistors dient. Die gewünschte Wichtung ist dann bekanntlich automatisch gegeben.

Bei einer monolithischen Realisierung der erfindungsgemäßen Schaltung empfiehlt es sich, die die zu verarbeitenden Digitalsignale liefernden Anlagen Z1, Z2 sowie die als Puffer an die zu beaufschlagenden Eingänge der beiden Wandler W1 und W2 vorgeschalteten Inverter IN in $I^2L$-Technik zu realisieren. Es können aber auch andere Logiksysteme verwendet werden. Auch die Verwendung von Bipolartransistoren ist nicht zwingend. So können die in Figur 1 und Figur 2 angegebenen Transistoren ohne weiteres durch selbstsperrende MOS-Feldeffekttransistoren ersetzt sein, wobei die Stromquellentransistoren durch p-Kanal-Transistoren und die anderen Transistoren durch n-Kanaltransistoren gegeben sein können. Es besteht ohne weiteres die Möglichkeit, einer Gateelektrode mehrere Source- bzw. Drainzonen zuzuordnen, und auf diese Weise eine Parallele zu den Mehr-Emitter-Transistoren bzw. Mehr-Kollektor-Transistoren zu schaffen.

**Patentansprüche**

1. Integrierbare Schaltung für Digital/Analog-Wandler, bei der die einzelnen, durch je einen Teil des zu verarbeitenden Digitalsignals beaufschlagten Signaleingänge (i = 1, 2, 3, 4) mit demselben Anschluß je einer ersten Diode ($D_i$, $d_i$) und der zweite Anschluß dieser ersten Diode mit demselben Anschluß je einer zweiten Diode ($D_i'$, $d_i'$) verbunden ist und außerdem am Ausgang je eines als Stromquelle betriebenen Transistors ($T_i$) liegt, während der andere Anschluß der zweiten Diode der von den einzelnen Signaleingängen gesteuerten Diodenpaare zur gemeinsamen Steuerung eines Ausgangsverstärkers (OP, op) vorgesehen ist, bei der weiterhin der stromführende Eingang der einzelnen Stromquellentransistoren über je einen Widerstand ($R_i$) von einem gemeinsamen Versorgungsanschluß her beaufschlagt ist, und bei der schließlich sowohl die einzelnen Diodenpaare einander gleich als auch die Stromquellentransistoren vomselben Typ sind, dadurch gekennzeichnet, daß jedem der vorgesehenen Stromquellentransistoren ($T_i$) mindestens je ein zweiter ihm gleicher Stromquellentransistor ($T_i'$) zugeordnet ist, indem die Stromeingangselektroden (Emitter) beider Stromquellentransistoren ($T_i$, $T_i'$) unmittelbar miteinander verbunden bzw. identisch sind, während die Stromausgangselektroden (Kollektoren) der beiden — jeweils einander zugeordneten — Stromquellentransistoren ($T_i$, $T_i'$) mit je einem von zwei übereinstimmenden, aber unabhängig voneinander wirkenden, digital gesteuerten Schaltungsteilen (W1, W2) der oben definierten Art, die zusammen mit den an den Stromeingangselektroden der Stromquellentransistoren ($T_i$, $T_i'$) liegenden, insbesondere digital gewichteten Widerständen ($R_i$) je einen Analog/Digital-Wandler bilden, verbunden sind.

2. Schaltung nach Anspruch 1, dadurch gekennzeichnet, daß die Gesamtheit der Stromquellentransistoren ($T_i$, $T_i'$) durch einen weiteren Transistor (T) zu Stromspiegel-Stromquellen ergänzt sind.

3. Schaltung nach Anspruch 1 oder 2, dadurch gekennzeichnet, daß die Stromquellentransistoren ($T_i$, $T_i'$) als Bipolartransistoren, insbesondere vom pnp-Typ, und die übrigen Transistoren der Schaltung, vor allem die Transistoren im Ausgangsverstärker, ebenfalls als Bipolartransistoren, insbesondere vom entgegengesetzten Typ zu dem der Stromquellentransistoren, realisiert sind.

4. Schaltung nach Anspruch 3, dadurch gekennzeichnet, daß die an den die Verbindung zum anderen Versorgungspotential ($+U_s$) bilden-

den Widerständen (R_i) jeweils angeschlossen Stromquellentransistoren (T_i, T_i') jeweils zu einem Transistor mit einem Emitteranschluß und einer der Anzahl der vereinigten Stromquellentransistoren entsprechenden Anzahl von Kollektoranschlüssen vereinigt sind.

5. Schaltung nach einem der Ansprüche 1 bis 4, dadurch gekennzeichnet, daß die von den vorgesehenen Stromquellentransistoren (T_i, T_i') jeweils beaufschlagten Diodenpaare (D_i, D_i' ; d_i, d_i, d_i') jeweils zu einem Zwei-Emitter-Transistoren (DT_i), insbesondere mit einem zum Leitungstyp der Stromquellentransistoren (T_i, T_i') entgegengesetzten Leitungstyp, vereinigt sind.

6. Schaltung nach einem der Ansprüche 1 bis 5, dadurch gekennzeichnet, daß die die Verbindung zwischen den Stromquellentransistoren (T_i, T_i') und dem anderen Versorgungspotential (+U_s) bildenden Widerstände (R_i) unter Zufügung weiterer Widerstände zu einem R-2R-Netzwerk ergänzt sind.

7. Schaltung nach einem der Ansprüche 1 bis 6, dadurch gekennzeichnet, daß die einzelnen an das gemeinsame Widerstandswerk (R_i) angeschlossenen Wandlerteile (W1, W2) mit je einem gegengekoppelten Operationsverstärker (OP, op) als Ausgangsverstärker versehen sind.

8. Schaltung nach einem der Ansprüche 1 bis 7, dadurch gekennzeichnet, daß die beiden zusammen mit dem gemeinsamen Widerstandswerk (R_i) je einen Digital/Analog-Wandler bildenden Schaltungsteile (W1, W2) als Ausgangsverstärker je einen als Stromspiegel geschalteten und mit seinem Emitter am Bezugspotential liegenden Transistor (T*) vom entgegengesetzten Leitungstyp zu dem der Stromquellentransistoren (T_i, T_i') aufweisen, dessen Kollektor über zwei als Differenzverstärker geschaltete Transistoren (τ1, τ2) vom entgegengesetzten Leitungstyp zu dem der Stromquellentransistoren mit dem anderen Versorgungspotential (+U_s) verbunden ist, und daß die Basis des einen Transistors (τ2) des Differenzverstärkers durch eine Referenzspanungsquelle (U_ref) und die Basis des anderen Transistors (τ1) über einen Inverter (I*) durch ein, insbesondere von einem zur digitalen Steuerung des betreffenden Wandlerteils (W1, W2) gehörenden Schaltungsteil (SG) geliefertes Umschaltesignal (+/—) beaufschlagt ist.

9. Schaltung nach einem der Ansprüche 1 bis 8, dadurch gekennzeichnet, daß die digitale Steuerung der einzelnen Signaleingänge (1, ... n) der über das gemeinsame Widerstandswerk (R_i) miteinander verbundenen Wandler über je einen Inverter (IN) erfolgt.

## Claims

1. An integratable circuit for digital/analogue converters, wherein the individual signal inputs (i = 1, 2, 3, 4), which are each supplied with a part of the digital signal which is to be processed, are connected to the similar terminal of each respective first diode (D_i, d_i) and the second terminal of this first diode is connected to the similar terminal of a respective second diode (D_i', d_i') and moreover to the output of a respective transistor (T_i) operated as a current source, whereas the other terminal of the second diode of the individual pairs of diodes, controlled by the respective signal inputs, commonly controls an output amplifier (OP, op), in which moreover the current-carrying input of the individual current source transistors is acted upon via a respective resistor (R_i) by a common supply terminal, and in which finally the individual pairs of diodes are identical to one another and the current source transistors are of the same type, characterised in that each of the current source transistors (T_i) is assigned at least one second current source transistors (T_i') of identical type, in that the current input electrodes (emitters) of the two current source transistors (T_i, T_i') are directly connected to one another and are identical, whereas the current output electrodes (collectors) of the two mutually-assigned current source transistors (T_i, T_i') are each connected to one of two digitally-controlled circuit components (W1, W2) of the above-defined type, which are identical but which operate independently of one another, and which, together with the resistors (R_i) which are connected to the current input electrodes of the current source transistors (T_i, T_i') are digitally-weighted, and in each case form an analogue/digital converter.

2. A circuit as claimed in Claim 1, characterised in that the current source transistors (T_i, T_i') as a whole are supplemented by a further transistor (T) to form current reflector current sources.

3. A circuit as claimed in Claim 1 or 2, characterised in that the current source transistors (T_i, T_i') are in the form of bipolar transistors, in particular of the pnp-type, and the other transistors of the circuit, in particular the transistors in the output amplifier, are likewise in the form of bipolar transistors, in particular of the opposite type to that of the current source transistors.

4. A circuit as claimed in Claim 3, characterised in that the current source transistors (T_i, T_i'), which are each connected to the resistors (R_i) which form the connection to the other supply potential (+U_s) are in each case combined to form a transistor with one emitter terminal and with a number of collector terminals corresponding to the number of combined current source transistors.

5. A circuit as claimed in one of Claims 1 to 4, characterised in that the pairs of diodes (D_i, D_i' ; d_i, d_i, d_i'), which are each acted upon by the provided current source transistors (T_i, T_i') are in each case combined to form a two-emitter transistor (DT_i), in particular of a conductivity type which is opposed to the conductivity type of the current source transistors (T_i, T_i').

6. A circuit as claimed in one of Claims 1 to 5, characterised in that the resistors (R_i), which form the connection between the current source transistors (T_i, T_i') and the other supply potential (+U_s) are supplemented by the addition of further resistors to form an R-2R-network.

7. A circuit as claimed in one of Claims 1 to 6, characterised in that the individual converter components (W1, W2), which are connected to the common resistance network ($R_i$), are each provided with an operational amplifier (OP, op) with negative feedback, as an output amplifier.

8. A circuit as claimed in one of Claims 1 to 7, characterized in that the two circuit components (W1, W2) which, together with the common resistance network ($R_i$), in each case form a digital/analogue converter, each comprise, as output amplifiers, a transistor (T*) of the opposite conductivity type to that of the current source transistors ($T_i$, $T_i'$) which is connected as a current reflector, connected by its emitter to the reference potential, and by its collector to the other supply potential ($+U_s$) via two transistors ($\tau 1$, $\tau 2$), which are connected as differential amplifiers, and are of the opposite conductivity type to that of the current source transistors, and that the base of the first transistors ($\tau 2$) of the differential amplifier is supplied by a reference voltage source ($U_{ref}$), and the base of the other transistor ($\tau 1$) is supplied, via an inverter (I*), with a switch-over signal ($+/-$) which is supplied in particular by a circuit component (SG) assigned to the digital control of the respective converter component (W1, W2).

9. A circuit as claimed in one of Claims 1 to 8, characterised in that the digital control of the individual signal inputs (1, ... n) of the converters, which are connected to one another via the common resistance network ($R_i$), in each case takes place via an inverter (IN).

**Revendications**

1. Circuit intégré pour un convertisseur numérique/analogique, dans lequel les différentes entrées de signaux (i = 1, 2, 3, 4), chargées par une partie respective du signal numérique devant être traité, sont reliées à la même borne d'une première diode respective ($D_i$, $d_i$) et la seconde borne de cette première diode est reliée à la même borne d'une seconde diode respective ($D_i'$, $d_i'$) et est en outre raccordée à la sortie d'un transistor respectif ($T_i$) fonctionnant en tant que source de courant, tandis que la seconde borne de la seconde diode du couple de diodes, commandé par les différentes entrées de signaux, est prévue pour réaliser la commande en commun d'un amplificateur de sortie (OP, op), et dans lequel, en outre, l'entrée placée sous tension des différents transistors formant sources de courant est chargée par l'intermédiaire d'une résistance respective ($R_i$), à partir d'une borne commune d'alimentation, et dans lequel, enfin, aussi bien les couples de diodes sont identiques entre eux et les transistors formant sources de courant sont du même type, caractérisé par le fait qu'à chacun des transistors prévus pour former sources de courant ($T_i$) est associé au moins un second transistor respectif formant source de courant ($T_i'$) identique au transistor précédent, par le fait que les électrodes d'entrée du courant (émetteurs) des deux transistors formant sources de courant ($T_i$, $T_i'$) sont reliés entre eux directement ou sont identiques, tandis que les électrodes de sortie du courant (collecteurs) des deux transistors formant source de courant ($T_i$, $T_i'$) — respectivement associés l'un à l'autre — sont reliées respectivement à l'une des deux parties de circuit à commande numérique (W1, W2) du type défini plus haut, qui sont identiques, agissent indépendamment l'une de l'autre et forment, conjointement avec les résistances ($R_i$) raccordées aux électrodes d'entrée du courant des transistors formant source de courant ($T_i$, $T_i'$) et notamment pondérées numériquement, des convertisseurs analogique/numérique respectifs.

2. Circuit suivant la revendication 1, caractérisé par le fait que tous les transistors formant sources de courant ($T_i$, $T_i'$) sont complétés par un transistor supplémentaire (T) de manière à former des sources de courant formant miroir de courant.

3. Circuit suivant la revendication 1 ou 2, caractérisé par le fait que les transistors formant sources de courant ($T_i$, $T_i'$) sont réalisés sous la forme de transistors bipolaires, notamment du type pnp, et les autres transistors du circuit, surtout les transistors situés dans l'amplificateur de sortie, sont également réalisés sous la forme de transistors bipolaires, notamment du type opposé à celui des transistors formant sources de courant.

4. Circuit suivant la revendication 3, caractérisé par le fait que les transistors formant sources de courant ($T_i$, $T_i'$) raccordés respectivement aux résistances ($R_i$) réalisant la liaison avec l'autre potentiel d'alimentation ($+U_s$) sont réunis pour former des transistors possédant une borne d'émetteur et un nombre de bornes de collecteurs, correspondant au nombre des transistors formant sources de courant réunis.

5. Circuit selon l'une des revendications 1 à 4, caractérisé par le fait que les couples de diodes ($D_i$, $D_i'$ ; $d_i$, $d_i$, $d_i'$), qui sont chargés respectivement par les transistors formant sources de courant ($T_i$, $T_i'$) prévus, sont réunis respectivement à un transistor ($DT_i$) à deux émetteurs, possédant notamment un type de conductivité opposé au type de conductivité des transistors formant sources de courant ($T_i$, $T_i'$).

6. Circuit suivant l'une des revendications 1 à 5, caractérisé par le fait que les résistances ($R_i$), qui établissent la liaison entre les transistors formant sources de courant ($T_i$, $T_i'$) et l'autre potentiel d'alimentation ($+U_s$), sont complétés, moyennant l'adjonction de résistances supplémentaires, pour former un réseau R-2R.

7. Circuit suivant l'une des revendications 1 à 6, caractérisé par le fait que les différentes parties de circuit (W1, W2), raccordées au réseau commun de résistances ($R_i$), comportent un amplificateur opérationnel (OP, op) à contre-réaction, en tant qu'amplificateur de sortie.

8. Circuit suivant l'une des revendications 1 à 7, caractérisé par le fait que les deux parties de circuit (W1, W2), qui constituent en association avec le réseau commun de résistances ($R_i$), un convertisseur numérique/analogique respectif, possèdent, en tant qu'amplificateur de sortie, un transistor respectif ($T^*$) branché en tant que miroir de courant dont l'émetteur est placé au potentiel de référence et qui est d'un type de conductivité opposé à celui des transistors formant sources de courant ($T_i$, $T_i'$), et dont le collecteur est relié par l'intermédiaire de deux transistors ($\tau 1$, $\tau 2$), branchés en tant qu'amplificateurs différentiels et possédant un type de conductivité opposé à celui des transistors formant sources de courant, à l'autre potentiel d'alimentation ($+U_s$), et que la base d'un transistor ($\tau 2$) de l'amplificateur différentiel est chargée par l'intermédiaire d'un inverseur ($I^*$) par un signal de commutation ($+/-$) délivré notamment par un élément de circuit (SG) faisant partie du système de commande numérique de la partie de circuit (W1, W2) considérée.

9. Circuit suivant l'une des revendications 1 à 6, caractérisé par le fait que la commande numérique des différentes entrées de signaux (1, ... n) des convertisseurs reliés entre eux par l'intermédiaire du réseau commun de résistances ($R_i$) est réalisée par l'intermédiaire d'inverseurs respectifs (IN).

# FIG 1

# FIG 2